# EUROPEAN PATENT SPECIFICATION

(11) **EP 3 098 198 B1**
(45) Date of publication and mention of the grant of the patent: **27.04.2022**
(21) Application number: 16168937.7
(22) Date of filing: 10.05.2016
(51) Int. Cl.: C01B 32/194

(54) **PRODUCTION METHOD OF GRAPHENE FOIL WITH A PRE-DEFINED NUMBER OF GRAPHENE LAYERS**
HERSTELLUNGSVERFAHREN VON GRAPHENFOLIE MIT EINER VORGEGEBENEN ANZAHL VON GRAPHENSCHICHTEN
PROCÉDÉ DE PRODUCTION D'UNE FEUILLE DE GRAPHÈNE AVEC UN NOMBRE PRÉDÉFINI DE COUCHES DE GRAPHÈNE

(30) Priority: 29.05.2015 PL 41252015
(43) Date of publication of application: 30.11.2016
(73) Proprietor: SIEC BADAWCZA LUKASIEWICZ - INSTYTUT MIKROELEKTRONIKI I FOTONIKI, 02-668 Warszawa (PL)
(72) Inventor: Krajewska, Aleksandra, 01-470 Warszawa (PL); Pasternak, Iwona, 02-698 Warszawa (PL); Przewloka, Aleksandra, 24-100 Pulawy (PL); Strupinski, Wlodzimierz, 01-934 Warszawa (PL)
(74) Representative: AOMB Polska Sp. z.o.o.

(56) References cited:
- CN-A- 104 029 431
- US-A1- 2012 070 612
- US-A1- 2012 128 983
- BIAN WU, HATICE M. TUNCER, MAJID NAEEM, BIN YANG, MATTHEW T. COLE, WILLIAM I. MILNE & YANG HAO: "Experimental demonstration of a transparent graphene millimetre wave absorber with 28% fractional bandwidth at 140 GHz", SCIENTIFIC REPORTS, vol. 4, 4130, 19 February 2014 (2014-02-19), page 1-7, XP002762576, DOI: 10.1038/srep04130

## Description

The present invention relates to a preparation method of graphene foil with a pre-defined number of graphene layers, which has been obtained using CVD graphene deposited on a metallic substrate (in particular a copper substrate) and subsequently transferred onto a polymer substrate, e.g. polymethyl methacrylate (PMMA) or other.

Graphene as a transparent, conductive and, at the same time, very thin material has aroused a profound interest of both the world of science and business. The widely described potential applications of graphene can be significantly extended through the implementation of materials obtained by a controlled assembly of multiple graphene layers. For instance, multilayer graphene can be used in both control and management of the thermal properties of nanostructures, as saturable absorbers in femtosecond lasers or electrical contacts in LEDs [1-4].

The controllable production of more than one graphene layer directly in a CVD growth process on metallic substrates is unattainable. In the case of the Cu substrate, growth is self-limited to one layer, only with small areas of two-three layers [5]. As regards Ni, CVD growth is accompanied by an uncontrolled unintentional process of carbon precipitation on the surface of metal from its volume, resulting in an uneven distribution of a random number of graphene layers, in consequence resembling a patchwork [6].

To the best knowledge of the Authors of the present invention, up to this point no similar solution for obtaining graphene foil with a controllable pre-defined number of graphene layers on an elastic polymer substrate has been published. The production methods of more than one layer presented so far predominantly include non-elastic substrates such as optical glass or quartz and are mainly based on adding successive graphene layers on top of graphene which is already on the target substrate. Moreover, the described techniques and examples are limited only to a few graphene layers. One of the procedures presented in the literature [7] entails transferring stacks of graphene/PMMA layers from copper foils detached from Cu through copper etching. A {PMMA/graphene/PMMA/graphene/}xN/quartz stack is the final product. Another reported production method of multiple graphene layers is based on repeating the transfer process of graphene from a Cu/SiO2/Si substrate using PMMA onto a graphene/Cu/SiO2/Si substrate and next onto a quartz substrate. At the first stage, this technique consists in obtaining the PMMA/graphene/graphene/Cu/SiO2/Si stack and afterwards using Cu etching the PMMA/graphene/graphene stack is transferred onto the quartz substrate [8]. The most commonly employed method is graphene transferring from copper with the use of PMMA through copper etching and placing graphene on the target substrate layer by layer, with PMMA removed after each transfer [9]. Most of all, the major disadvantages of these solutions include the number of iterations to be performed to obtain multiple layers as well as the use of rigid substrates such as optical glass or quartz, which can get damaged when applying successive layers. In addition, such a substrate becomes the target substrate, thus precluding the detachment of graphene multilayers and their transfer onto other surfaces as graphene is permanently joined to a substrate of this type. Furthermore, according to the information available to the Authors of the present invention, up to this point no solution based on the transfer of a PMMA/graphene substrate graphene/metal stack (in particular graphene/Cu) has been reported, at least for the following reasons:
- copper is rapidly oxidized, which is likely to result in an uncontrollable detachment of graphene layers from such a substrate and degradation (decomposition) of these layers; therefore, to the knowledge of an expert, a copper substrate is not suitable for supporting graphene layers;
- each type of research works as well as industrial production processes necessitate characterization of the obtained graphene layers; measurements using transmission techniques in the case of metallic substrates are fundamentally impossible due to the fact that a metallic substrate is non-transparent; the number of graphene monolayers arranged on one another is key to the manufacture of graphene multilayers; in general, this number can be determined using Raman spectroscopy; however, if layers on the metallic substrate are not grown but transferred onto this substrate, the analysis of graphene layers using this method is restricted to the possibility of stating whether a graphene layer is or is not present on the substrate;
- limited availability of a material in the form of graphene deposited on a metallic substrate; typically, graphene produced using epitaxial methods on metallic substrates is in the form of small-sized wafers (e.g. 1cm2), which is not sufficient to undergo technological operations such as the ones anticipated in the present invention (i.e. cutting and arranging on one another).

The production method of graphene foil with a pre-defined number of graphene layers proposed by the Authors is characterized in that foil with any number of layers can be obtained. Such prepared stack of graphene layers can be transferred onto any flat target substrate or remain in the form of foil.

That is why, the aim of the present invention is to develop a preparation method of graphene foil with a pre-defined number of graphene layers, which has been obtained using CVD graphene deposited on a metallic substrate (in particular a copper substrate) and subsequently transferred onto a polymer substrate, e.g. polymethyl methacrylate (PMMA) or other.

As a result of non-compliance with the rules known to the experts, i.e. cutting a polymer/graphene/metal stack in two and, after prior processing, placing one of them on top of the other, thus using it as a substrate, it become possible to iterate (repeat) the process and obtain graphene foil with a large number of graphene layers (e.g. several dozen) in a much shorter process than transferring single layers onto a target substrate (e.g. quartz), known in the present state of the art.

According to the present invention, the production method of graphene foil with a pre-defined number of graphene layers , according to claim 1, can be divided into the following stages:
a) producing graphene on a metallic substrate;
b) depositing a polymer layer on the graphene surface;
c) separating the polymer/graphene stack from the metallic substrate;
d) transferring the obtained polymer/graphene stack directly onto the metallic substrate with at least one graphene layer deposited on top;
e) separating the polymer/graphene/graphene stack from the metallic substrate,
   and is characterized in that it comprises the stage of transferring of polymer/graphene with the target number of layers on a substrate, being a porous sponge,
   wherein the following stages take place between stages d) and e):
      f) dividing the obtained polymer/graphene/graphene/metal stack at least into two parts, preferably with an even surface area;
      g) removing polymer from one of the abovementioned parts of the polymer/graphene/graphene/metal stack;
      h) separating the polymer/graphene/graphene stack from the latter part of the metallic substrate;
      i) transferring the polymer/graphene/graphene stack obtained in step h) onto the graphene/graphene/metal stack produced in step g),
      wherein stages d) - i) are repeated until the target number of graphene wafers is obtained.

Preferably, the metallic substrate is made of copper, nickel, platinum, gold, silver or alloys of these metals.

Preferably, polymethyl methacrylate or other polymer insoluble in water, conveniently polydimethylsiloxane or cellulose acetate, is the used polymer.

Preferably, stage a) is performed using the chemical vapour deposition method.

Preferably, stage b) is performed using either spin-coating or dropping.

Preferably, stages c) and/or e) and/or h) are performed using the electrochemical delamination method in an electrolyte solution, conveniently potassium chloride.

Preferably, stages c) and/or e) and/or h) are performed by etching the metallic substrate using an aqueous etching solution, conveniently an aqueous solution of ammonium persulfate.

Preferably, after stage c) the polymer/graphene stack is cleaned from the electrolyte solution and the etchant, conveniently using a constant controllable stream of deionized water.

Preferably, stage f) is performed using a pair of scissors, a paper cutter, a scalpel or laser.

Preferably, stage g) is performed using a dissolvent, conveniently acetone, anisole, chloroform, acetic acid or tetrahydrofuran.

Preferably, the outcome polymer/graphene x N/metal stack is gradually heated to the temperature of around 130°C, conveniently at a speed of approximately 1°C/minute.

Preferably, the polymer/graphene x N/metal stack is next annealed at around 130°C in a protective atmosphere and either at atmospheric pressure or, most suitably, pressure lowered to 5x10-3, conveniently for 1-5 hours.

Preferably, after stage a) the quality of the graphene layer on the metallic substrate is confirmed by carrying out Raman spectroscopy measurements.

The invention will be presented in detail as a preferred embodiment with reference to the attached images, of which:
fig. 1 shows a Raman spectrum of graphene on copper foil (a) and an optical picture of the copper surface covered with graphene (b),
fig. 2 shows the preparation method of graphene foil with a pre-defined number of graphene layers,
fig. 3 shows graphene foil with a varying number of graphene layers, whereas
fig. 4 shows the results of transmission measurements for graphene foil with a different number of graphene layers.

### Preferred embodiment of the invention

The present method enables the rapid production of graphene foil with a pre-defined number of graphene layers. In addition, it is possible to transfer the PMMA/graphene xN stack on any other substrate, e.g. glass, silicon or polymer, which in consequence significantly increases the range of possible graphene applications. Apart from that, this procedure allows one to transfer an unlimited number of graphene layers and guarantees saving of the preparation time of a given substrate with a higher number of graphene layers than when compared with the standard "layer by layer" transfer method.

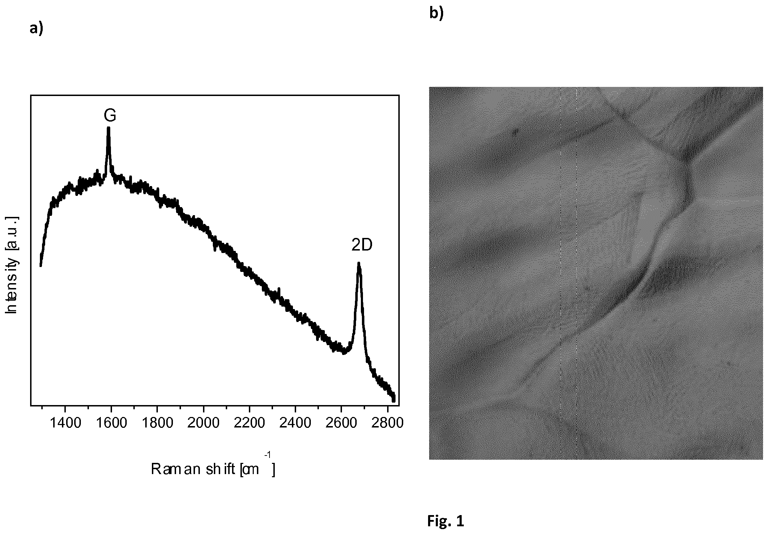

Graphene in the form of a monolayer was produced on a 25 µm thick copper foil using the chemical vapour phase deposition method, as described in [10]. The high quality of the outcome graphene layer was confirmed by both spectroscopic measurements and optical microscopy. Fig. 1 presents a Raman spectrum proving the presence of a monoatomic carbon layer and an optical image of copper surface covered with graphene.

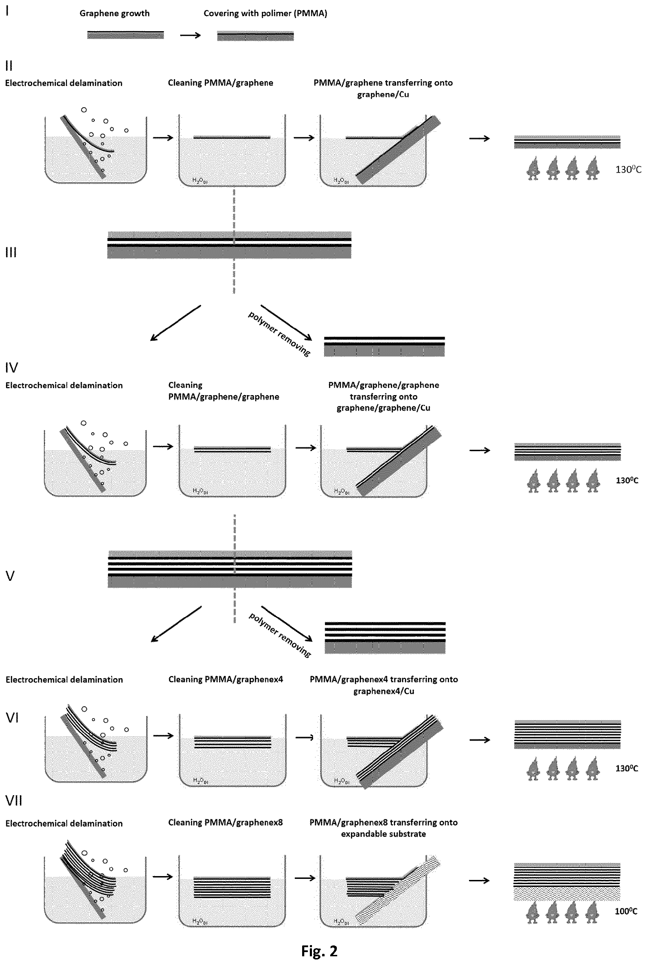

Next, before separating the monoatomic graphene layer from the copper substrate on which it was grown, a thin layer of polymethyl methacrylate (PMMA) was deposited on top through spin-coating. This polymer protects graphene against any damage or cracking during its transferring onto other substrate. The graphene separation process was carried out using the electrochemical delamination method [10]. Graphene on copper covered with a PMMA layer, which serves as a cathode, is introduced into the electrolyte solution (most frequently potassium chloride) at a pre-defined speed and polarized using an external voltage source. Due to the formation of hydrogen in a gaseous form as a result of the electrolysis of water, the PMMA/graphene stack gets separated from the copper substrate. Afterwards, the graphene/PMMA layer floating on the surface of the electrolyte solution was cleaned from the salt solution using a constant controllable stream of deionized water (DI) and transferred onto the graphene/copper substrate. The obtained PMMA/graphene/graphene/copper stack was annealed at 130°C in an atmosphere of air in order to both improve adhesion and eliminate water. Next, the PMMA/graphene/graphene/copper stack can be separated from the copper substrate once again employing the electrochemical delamination method and repeating all of the abovementioned steps, thus achieving graphene foil with two graphene layers. Such foil should be transferred onto a substrate having a well-developed surface (the well-developed surface prevents a permanent adherence of the PMMA/graphene/graphene sample and plays the role of a temporary substrate), e.g. a porous sponge, so that the graphene layers were on top of PMMA and subsequently annealed at 100°C. To quickly and easily produce graphene foil with a higher number of graphene layers, for instance 8 or 24 layers, the PMMA/graphene/graphene/copper stack has to be cut in two using a pair of scissors. After the cutting step, the PMMA layer should be removed from one part with an acetone solution and subsequently rinsed with ethanol, deionized water and left to be annealed at 100°C on a substrate with a well-developed surface. The remaining part with the PMMA/graphene/graphene/copper stack has to be then separated from the copper substrate again and transferred onto the graphene/graphene/copper substrate prepared earlier. The PMMA/graphene x 4/ copper stack can be separated once again, obtaining graphene foil with four layers of graphene or cut in two, repeating the abovementioned steps, thus achieving graphene foil with eight graphene layers. This graphene transfer process can be continued until obtaining the final structure with a pre-defined number of graphene layers. At the same time, depending on the designed number of layers, it is possible to end the process at any stage. The number of graphene layers does not have to be the multiple of a previous stack of graphene layers; it is feasible to produce the stacks simultaneously and join them in any combination to achieve any number of graphene layers. The applied scheme for producing graphene foil, taking the example of graphene obtained on copper foil (fig. 2), can be divided into the following stages:
I - producing a graphene layer on a copper substrate; spin-coating of a thin PMMA layer on top of graphene/copper,
II - separating the PMMA/graphene/copper stack using the electrochemical delamination method, rinsing with DI water, transferring onto the graphene/copper substrate, annealing at 130°C,
III - cutting the PMMA/graphene/graphene/copper in two, removing the PMMA layer from one part,
IV - separating the PMMA/graphene/graphene/copper stack from the copper substrate, rinsing with DI water, transferring the PMMA/graphene/graphene stack onto the graphene/graphene/copper stack, annealing the stack at 130°C,
V - cutting the PMMA/graphene/graphene/graphene/graphene/copper in two, removing the PMMA layer from one part,
VI - separating the PMMA/graphene/graphene/graphene/graphene/copper stack from the copper substrate, rinsing with DI water, transferring the PMMA/graphene/graphene/graphene/graphene stack onto the graphene/graphene/graphene/graphene/copper stack, annealing the sample at 130°C,
VII - separating the PMMA/graphene x 8/copper stack from the copper substrate, rinsing with DI water, transferring the PMMA/graphene x 8 stack on a carrier, e.g. a porous sponge, annealing the sample at 100°C.

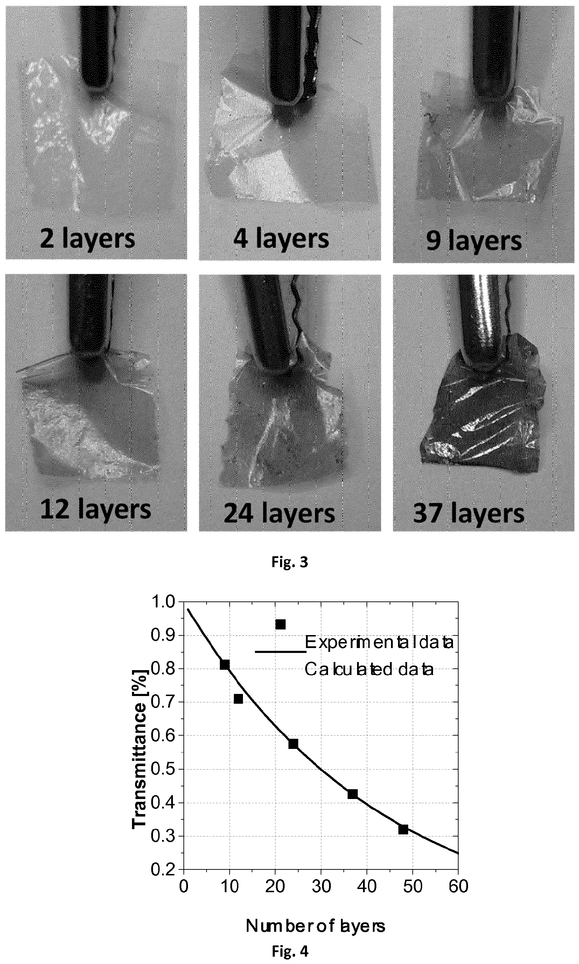

Fig. 3 presents graphene foil with a different number of graphene layers, i.e. 2, 4, 9, 12, 24 and 37 layers. It can be noticed that as the number of layers is higher, the colour of graphene foil gets darker, which suggests increased light absorption. For confirmation, transmission measurements as a function of the number of the deposited layers were carried out using a continuously operating laser with a power of 1 mW for a wavelength of 1550 nm. Fig. 4 presents the results of transmission measurements for graphene foil with a varying number of graphene layers as well as multilayer graphene transmission calculated theoretically using the following formula: T(N)=(1-πα)N, where N is the number of layers and α is a material constant. When increasing the number of graphene layers, transmission is changed from 0.81% for 9 layers to 0.43% for 37 layers, which stays in agreement with the theoretical value.

### References

The numbers in brackets given above refer to the following publications:
[1] Suchismita Ghosh, Wenzhong Bao, Denis L. Nika, Samia Subrina, Evghenii P. Pokatilov, Chun Ning Lau, Alexander A. Balandin Dimensional crossover of thermal transport in few-layer graphene Nature Materials 9, 555-558 (2010)
[2] M. F. Shahil, Alexander A. Balandin Graphene-Multilayer Graphene Nanocomposites as Highly Efficient Thermal Interface Materials Khan Nano Lett. 2012, 12, 861-867
[3] Grzegorz Sobon, Jaroslaw Sotor, Iwona Pasternak, Aleksandra Krajewska, Wlodek Strupinski, Krzysztof M. Abramski All-polarization maintaining, graphene-based femtosecond Tm-doped all-fiber laser Optics Express Vol. 23, Issue 7, pp. 9339-9346 (2015)
[4] Byung-Jae Kim, Chongmin Lee, Younghun Jung, Kwang Hyeon Baik, Michael A. Mastro, Jennifer K. Hite, Charles R. Eddy Jr., Jihyun Kim Large-area transparent conductive few-layer graphene electrode in GaN-based ultra-violet light-emitting diodes Applied Physics Letters 99 143101 (2011)
[5] Li, X.; Cai, W.; An, J.; Kim, S.; Nah, J.; Yang, D.; Piner, R.; Velamakanni, A.; Jung, I.; Tutuc, E.; Banerjee, S. K.; Colombo, L.; Ruoff, R. S. Large-Area Synthesis of High-Quality and Uniform Graphene Films on Copper Foils Science 2009, 324, 1312-1314
[6] Hye Jin Park, Jannik Meyer, Siegmar Roth, Viera Skakalova Growth and properties of few-layer graphene prepared by chemical vapor deposition Carbon vol. 48, pp. 1088-1094 (2010)
[7] K. Batrakov, P. Kuzhir, S. Maksimenko, A. Paddubskaya, S. Voronovich, Ph Lambin, T. Kaplas, Yu Svirko Flexible transparent graphene/polymer multilayers for efficient electromagnetic field absorption Scientific Reports 4, 7191
[8] Bian Wu, Hatice M. Tuncer, Majid Naeem, Bin Yang, Matthew T. Cole, William I. Milne, Yang Hao Experimental demonstration of a transparent graphene millimetre wave absorber with 28% fractional bandwidth at 140 GHz Scientific Reports 4, 4130
[9] Tianhua Yu, Changdong Kim, Bin Yu Highly Conductive 3D Nano-Carbon: Stacked Multilayer Graphene System with Interlayer Decoupling arXiv:1103.4567v3
[10] Tymoteusz Ciuk, Iwona Pasternak, Aleksandra Krajewska, Jan Sobieski, Piotr Caban, Jan Szmidt, Wlodek Strupinski, Properties of chemical vapor deposition graphene transferred by high-speed electrochemical delamination J. Phys. Chem. C, 117, 20833-20837 (2013).

## Claims

1. A production method of graphene foil with a pre-defined number of graphene layers covering the following stages:
a) producing graphene on a metallic substrate;
b) depositing a polymer layer on the graphene surface;
c) separating the polymer/graphene stack from the metallic substrate
d) transferring the obtained polymer/graphene stack directly onto the metallic substrate with at least one graphene layer deposited on top;
e) separating the polymer/graphene/graphene stack from the metallic substrate
**characterized in that** it comprises the stage of transferring polymer/graphene with the target number of layers onto a substrate, being a porous sponge;
wherein the following stages are included between stages d) and e):
f) dividing the obtained polymer/graphene/graphene/metal stack at least into two parts, preferably with an identical surface area,
g) removing polymer from one of the abovementioned parts of the polymer/graphene/graphene/metal stack,
h) separating the polymer/graphene/graphene stack from the latter part of the metallic substrate,
i) transferring the polymer/graphene/graphene stack obtained in step h) onto the graphene/graphene/metal stack produced in step g);
wherein stages d) - i) are repeated until the target number of graphene wafers is obtained.

2. The method according to claim 1, **characterized in that** the metallic substrate is made of copper, nickel, platinum, gold, silver or alloys of these metals.

3. The method according to any of claims 1 - 2, **characterized in that** polymethyl methacrylate or other polymer insoluble in water, conveniently polydimethylsiloxane or cellulose acetate, is the used polymer.

4. The method according to claim 1 **characterized in that** stage a) is performed using the chemical vapour deposition method.

5. The method according to claim 1 **characterized in that** stage b) is performed using either spin-coating or dropping.

6. The method according to any of claims 1 - 5 **characterized in that** stages c) and/or e) and/or h) are performed using electrochemical delamination in an electrolyte solution, conveniently potassium chloride.

7. The method according to any of claims 1 - 5 **characterized in that** stages c) and/or e) and/or h) are performed by etching the metallic substrate using an aqueous etching solution, conveniently an aqueous solution of ammonium persulfate.

8. The method according to any of claims 1 - 7 **characterized in that** after stage c) the polymer/graphene stack is cleaned from the electrolyte solution and the etchant, conveniently using a constant controllable stream of deionized water.

9. The method according to any of claims 1 - 8 **characterized in that** stage f) is performed using a pair of scissors, a paper cutter, a scalpel or laser.

10. The method according to any of claims 1 - 9, **characterized in that** stage g) is performed using a dissolvent, conveniently acetone, anisole, chloroform, acetic acid or tetrahydrofuran.

11. The method according to any of claims 1 - 10, **characterized in that** the outcome polymer/graphene x N/metal stack is gradually heated to the temperature of around 130°C, conveniently at a speed of approximately 1°C/minute and subsequently possibly the polymer/graphene x N/metal stack is annealed at around 130°C in a protective atmosphere and either at atmospheric pressure or, most suitably, pressure lowered to 5x10-3, conveniently for 1-5 hours.

12. The method according to claim 1, **characterized in that** after stage a) the quality of the graphene layer on the metallic substrate is confirmed by carrying out Raman spectroscopy measurements.

## Patentansprüche

1. Ein Verfahren zur Herstellung von Graphenfolien mit einer bestimmten Anzahl von Graphenschichten, das die folgenden Schritte umfasst:
a) Herstellung von Graphen auf einem metallischen Substrat;
b) Aufbringen einer Polymerschicht auf die Graphenoberfläche;
c) Trennen des Polymer/Graphen-Stapels von dem metallischen Substrat
d) Übertragen des erhaltenen Polymer/Graphen-Stapels direkt auf das Metallsubstrat mit mindestens einer darauf abgeschiedenen Graphenschicht;
e) Trennen des Polymer/Graphen/Graphen-Stapels von dem metallischen Substrat
**dadurch gekennzeichnet, dass** es den Schritt des Übertragens von Polymer/Graphen mit der angestrebten Anzahl von Schichten auf ein Substrat umfasst, das ein poröser Schwamm ist;
wobei die folgenden Schritte zwischen den Schritten d) und e) vorgesehen sind:
f) Aufteilung des erhaltenen Polymer/Graphen/Graphen/Metall-Stapels in mindestens zwei Teile, vorzugsweise mit identischer Oberfläche,
g) Entfernen von Polymer aus einem der oben genannten Teile des Polymer/Graphen/Graphen/Metall-Stapels,
h) Trennen des Polymer/Graphen/Graphen-Stapels von dem letzten Teil des Metallsubstrats,
i) Übertragen des in Schritt h) erhaltenen Polymer/Graphen/Graphen-Stapels auf den in Schritt g) hergestellten Graphen/Graphen/Metall-Stapel;
wobei die Schritte d) - i) wiederholt werden, bis die angestrebte Anzahl von Graphenscheiben erreicht ist.

2. Verfahren nach Anspruch 1, **dadurch gekennzeichnet, dass** das metallische Substrat aus Kupfer, Nickel, Platin, Gold, Silber oder aus Legierungen dieser Metalle besteht.

3. Verfahren nach einem der Ansprüche 1 -2, **dadurch gekennzeichnet, dass** Polymethylmethacrylat oder ein anderes in Wasser unlösliches Polymer, vorzugsweise Polydimethylsiloxan oder Celluloseacetat, das verwendete Polymer ist.

4. Verfahren nach Anspruch 1, **dadurch gekennzeichnet, dass** der Schritt a) nach dem Verfahren der chemischen Abscheidung aus der Dampfphase durchgeführt wird.

5. Verfahren nach Anspruch 1, **dadurch gekennzeichnet, dass** der Schritt b) entweder durch Schleuderbeschichtung oder durch Tropfenbildung durchgeführt wird.

6. Verfahren nach einem der Ansprüche 1 - 5, **dadurch gekennzeichnet, dass** die Schritte c) und/oder e) und/oder h) unter Verwendung elektrochemischer Delamination in einer Elektrolytlösung, vorzugsweise Kaliumchlorid, durchgeführt werden.

7. Verfahren nach einem der Ansprüche 1 -5, **dadurch gekennzeichnet, dass** die Schritte c) und/oder e) und/oder h) durch Ätzen des Metallsubstrats mit einer wässrigen Ätzlösung, vorzugsweise einer wässrigen Lösung von Ammoniumpersulfat, durchgeführt werden.

8. Verfahren nach einem der Ansprüche 1 -7, **dadurch gekennzeichnet, dass** nach Schritt c) der Polymer/Graphen-Stapel von der Elektrolytlösung und dem Ätzmittel gereinigt wird, vorzugsweise unter Verwendung eines konstanten, steuerbaren Stroms von entionisiertem Wasser.

9. Verfahren nach einem der Ansprüche 1-8, **dadurch gekennzeichnet, dass** Schritt f) mit einer Schere, einem Papierschneider, einem Skalpell oder einem Laser durchgeführt wird.

10. Verfahren nach einem der Ansprüche 1-9, **dadurch gekennzeichnet, dass** der Schritt g) mit einem Lösungsmittel, vorzugsweise Aceton, Anisol, Chloroform, Essigsäure oder Tetrahydrofuran, durchgeführt wird.

11. Verfahren nach einem der Ansprüche 1 -10, **dadurch gekennzeichnet, dass** der entstandene Polymer/Graphen x N/Metall-Stapel allmählich auf eine Temperatur von etwa 130°C erhitzt wird, zweckmäßigerweise mit einer Geschwindigkeit von etwa 1°C/Minute, und anschließend möglicherweise der Polymer/Graphen x N/Metall-Stapel bei etwa 130°C in einer Schutzatmosphäre und entweder bei Atmosphärendruck oder, was am geeignetsten ist, bei einem auf 5x10-3 verringerten Druck, zweckmäßigerweise für 1-5 Stunden, geglüht wird.

12. Verfahren nach Anspruch 1, **dadurch gekennzeichnet, dass** nach Schritt a) die Qualität der Graphenschicht auf dem Metallsubstrat durch die Durchführung von Raman-Spektroskopie-Messungen bestätigt wird.

## Revendications

1. Une méthode de production de feuille de graphène avec un nombre prédéfini de couches de graphène comprenant les étapes suivantes :
a) production de graphène sur un substrat métallique ;
b) dépôt d'une couche de polymère sur la surface du graphène ;
c) séparation de l'empilement polymère/graphène à partir du substrat métallique
d) transfert de l'empilement polymère/graphène obtenu directement sur le substrat métallique avec au moins une couche de graphène déposée sur le dessus ;
e) séparation de l'empilement polymère/graphène/graphène à partir du substrat métallique
**caractérisée en ce qu'elle** comprend l'étape du transférer du polymère/graphène avec le nombre souhaité de couches sur un substrat, qui est une éponge poreuse ;
dans laquelle les étapes suivantes sont incluses entre les étapes d) et e) :
f) division de l'empilement polymère/graphène/graphène/métal obtenu au moins en deux parties, de préférence avec une surface identique,
g) enlèvement du polymère à partir d'une des parties susmentionnées de l'empilement polymère/graphène/graphène/métal,
h) séparation de l'empilement polymère/graphène/graphène à partir de la dernière partie du substrat métallique,
i) transfert de l'empilement polymère/graphène/graphène obtenu à l'étape h) sur l'empilement graphène/graphène/métal produit à l'étape g) ;
dans laquelle les étapes d) à i) sont répétées jusqu'à ce que le nombre souhaité de plaquettes de graphène soit obtenu.

2. La méthode selon la revendication 1, **caractérisée en ce que** le substrat métallique est constitué de cuivre, de nickel, de platine, d'or, d'argent ou d'alliages de ces métaux.

3. La méthode selon l'une quelconque des revendications 1-2, **caractérisée en ce que** le polymère utilisé est le polyméthacrylate de méthyle ou un autre polymère insoluble dans l'eau, de préférence le polydiméthylsiloxane ou l'acétate de cellulose.

4. La méthode selon la revendication 1, **caractérisée en ce que** l'étape a) est réalisée en utilisant la méthode de dépôt chimique en phase vapeur.

5. La méthode selon la revendication 1, **caractérisée en ce que** l'étape b) est réalisée en utilisant soit le revêtement par centrifugation, soit l'égouttage.

6. La méthode selon l'une quelconque des revendications 1 à 5, **caractérisée en ce que** les étapes c) et/ou e), et/ou h) sont réalisées par délamination électrochimique dans une solution d'électrolyte, de préférence du chlorure de potassium.

7. La méthode selon l'une quelconque des revendications 1 à 5, **caractérisée en ce que** les étapes c) et/ou e), et/ou h) sont réalisées par gravure du substrat métallique à l'aide d'une solution de gravure aqueuse, de préférence une solution aqueuse de persulfate d'ammonium.

8. La méthode selon l'une quelconque des revendications 1 à 7, **caractérisée en ce que** après l'étape c), l'empilement polymère/graphène est nettoyé de la solution d'électrolyte et de l'agent de gravure, en utilisant de préférence un courant constant contrôlable d'eau désionisée.

9. La méthode selon l'une quelconque des revendications 1 à 8, **caractérisée en ce que** l'étape f) est réalisée à l'aide d'une paire de ciseaux, d'un coupe-papier, d'un scalpel ou d'un laser.

10. La méthode selon l'une quelconque des revendications 1 à 9, **caractérisée en ce que** l'étape g) est réalisée en utilisant un dissolvant, de préférence l'acétone, l'anisole, le chloroforme, l'acide acétique ou le tétrahydrofurane.

11. La méthode selon l'une quelconque des revendications 1 à 10, **caractérisée en ce que** l'empilement polymère/graphène x N/métal résultant est progressivement chauffé jusqu'à une température d'environ 130°C, de préférence à une vitesse d'environ 1°C/minute et ensuite, éventuellement, l'empilement polymère/graphène x N/métal est recuit à environ 130°C dans une atmosphère protectrice et soit à la pression atmosphérique, soit, plus convenablement, à une pression abaissée à 5x10-3, de préférence pendant 1-5 heures.

12. La méthode selon la revendication 1, **caractérisée en ce que** après l'étape a), la qualité de la couche de graphène sur le substrat métallique est confirmée en effectuant des mesures de spectroscopie Raman.
